# EUROPÄISCHE PATENTSCHRIFT

(11) **EP 1 042 812 B1**
(45) Veröffentlichungstag und Bekanntmachung des Hinweises auf die Patenterteilung: **09.05.2007**
(21) Anmeldenummer: 98966585.6
(22) Anmeldetag: 18.12.1998
(51) Int. Cl.: H01L 27/12

(54) **VERFAHREN ZUR HERSTELLUNG EINES HALBLEITERSUBSTRATS MIT VERSENKTER ISOLATIONSSCHICHT FÜR INTEGRIERTE SCHALTUNGEN**
METHOD OF MAKING A SEMICONDUCTOR SUBSTRATE WITH EMBEDDED ISOLATING LAYER FOR INTEGRATED CIRCUITS
PROCÉDÉ DE FABRICATION D'UN SUBSTRAT SEMICONDUCTEUR A COUCHE D'ISOLATION NOYEE POUR CIRCUIT INTEGRE

(30) Priorität: 22.12.1997 DE 19758349; 08.10.1998 DE 19847440
(43) Veröffentlichungstag der Anmeldung: 11.10.2000
(73) Patentinhaber: IHP GmbH-Innovations for High Performance Microelectronics/Institut für innovative Mikroelektronik, 15230 Frankfurt (Oder) (DE)
(72) Erfinder: ERZGRÄBER, Heide, B., D-15230 Frankfurt (DE); BOLZE, Klaus-Detlef, D-15232 Frankfurt (DE); GRABOLLA, Thomas, D-15232 Frankfurt (DE); WOLFF, André, D-15230 Frankfurt (DE)
(74) Vertreter: Eisenführ, Speiser & Partner
(86) Internationale Anmeldenummer: PCT/DE1998/003794
(87) Internationale Veröffentlichungsnummer: WO 1999/033114

(56) Entgegenhaltungen:
- US-A- 4 910 165
- US-A- 5 548 150
- US-A- 5 736 749
- NAM C -M ET AL: "HIGH-PERFORMANCE PLANAR INDUCTOR ON THICK OXIDIZED POROUS SILICON (OPS) SUBSTRATE" IEEE MICROWAVE AND GUIDED WAVE LETTERS, Bd. 7, Nr. 8, 1. August 1997, Seiten 236-238, XP000658631
- PATENT ABSTRACTS OF JAPAN vol. 097, no. 007, 31. Juli 1997 & JP 09 082968 A (TOSHIBA CORP), 28. März 1997
- BARLA K ET AL: "SOI TECHNOLOGY USING BURIED LAYERS OF OXIDIZED POROUS SI" IEEE CIRCUITS AND DEVICES MAGAZINE, 1. November 1987, Seiten 11-15, XP000615747

## Beschreibung

Die Erfindung bezieht sich auf ein Verfahren zur Herstellung einer integrierten Schaltung mit verringerten parasitären kapazitiven Einflüssen.

Die Verringerung parasitärer kapazitiver Einflüsse spielt insbesondere in den modernen CMOS-Technologien eine immer größer werdende Rolle. Werden integrierte Schaltungen mit Bipolar-Technologien realisiert, können durch Verwendung hochohmiger oder semiisolierender Substrate die substratbedingten kapazitiven und ohmschen Verluste von Induktivitäten oder anderen passiven Schaltungselementen gering gehalten werden. Es ist jedoch davon auszugehen, daß CMOS-Technologien wegen geringerer Kosten, eines geringen Leistungsverbrauchs und geringerer Abmessungen bevorzugt werden.

Die Integration passiver Elemente wie z. B. von Induktivitäten ist eine dringende Notwendigkeit insbesondere für die Realisierung monolithischer RF Transceiver Schaltkreise auf Silizium-Substraten. Im GHz-Bereich wird zwischen den Blöcken eine Impedanz-Anpassung erforderlich, für die diese passiven Elemente benötigt werden. Erfüllen CMOS-Technologien die Anforderungen zur Herstellung von RF Transceivern für zellulare Systeme oder LAN, bedeutet dies jedoch, daß aufgrund der zumeist verwendeten niederohmigen Si-Substrate (typisch 1 - 10 Ωcm) die gewünschten hohen Güten der Induktivitäten nicht a priori erreicht werden können. Die Optimierung dieser passiven Komponenten bedeutet vor allem die Maximierung des Gütefaktors (Q) durch eine Minimierung der Widerstandsverluste und der kapazitiven Parasitics. Die substratbedingten Verluste können reduziert werden, indem die Spiralbahn der Induktivität möglichst weit vom Silizium-Substrat entfernt wird - z. B. indem bei einem Mehrebenen-Leitbahnsystem die oberste(n) Ebene(n) für die Spirale verwendet wird, so daß sich aufgrund mehrerer Zwischenebenen-Isolierschichten in der Summe eine ausreichend dicke Isolation zwischen Spirale und Substrat ergibt. Da CMOS-Technologien mit Abmessungen ≤0.5 µm jedoch i.a. relativ dünne Isolierschichten verwenden, können bei niederohmigen Silizium-Substraten die Verluste ohne zusätzliche Maßnahmen nicht ausreichend gering gehalten werden. Zur Reduzierung der substratbedingten Verluste wurden bisher solche Varianten wie Verwendung von hochohmigen Silizium-Wafern, Verwendung von SOl-Substraten (auf Basis hochohmiger Silizium-Wafer), Verwendung von SOS-Substraten, Entfernung von Silizium unter der Spirale (Luftbrücke), Verwendung von Dielektrika mit geringerer relativer Dielektrizitätskonstante als von Siliziumdioxid, z.B. Polymere, sowie Realisierung der Metallspirale in einer mehrere jum dicken Metallschicht über einer sehr dicken Isolierschicht, wobei beide Schichten zusätzlich oberhalb des für die Schaltungen benötigten CMOS-Aufbaus zu realisieren sind, vorgeschlagen. Diese Varianten haben den Nachteil, daß die etablierten CMOS-Technologien modifiziert werden müssen bzw. die Halbleitersubstrate teurer sind. Auch sind diese Varianten nicht generell für alle weiteren passiven Elemente einer integrierten Schaltung, wie insbesondere Widerstände, Kapazitäten, Leitbahnen und Bondinseln, die ebenfalls mit parasitären kapazitiven Einflüssen behaftet sind, anwendbar.

Aus der US 5,548,150 ist es bekannt, zur Verringerung parasitärer kapazitiver Einflüsse eine partielle, aus porösem Silizium bestehende Schicht unterhalb einer planaren Induktivität vorzusehen.

Die US 4,910,165 beschreibt ein Verfahren zur Herstellung eines Substrats mit einer Siliziumschicht auf einem Isolator (SOI).

Aus dem Dokument C. M. Nam et al: "High-Performance planar inductor on thick oxidized porous silicon (OPS) substrate", IEEE Microwave and Guided Wave Letters, Bd. 7, Nr. 8, 1. August 1997, ist es bekannt, eine planare Induktivität auf einem Substrat mit einer dicken, oxidierten porösen Siliziumschicht vorzusehen.

Die US 5,736,749 beschreibt einen integrierten Schaltkreis mit einer Induktivität, unterhalb derer eine Schicht aus porösem Silizium angeordnet ist. Über dieser Schicht ist eine dünne Isolatorschicht angeordnet.

Aus der JP 09 082968 A ist ein Verfahren zur Herstellung eines SOI-Substrats bekannt.

Aus dem Dokument K. Barla et al: IEEE Circuits and Devices Magazine, 1. November 1987, Seiten 11 - 15 ist eine SOI-Technologie unter Verwendung vergrabener, oxidierter poröser Siliziumschichten bekannt.

Aufgabe der Erfindung ist es, ein Verfahren zur Herstellung einer integrierten Schaltung mit verringerten parasitären kapazitiven Einflüssen vorzuschlagen, bei denen die parasitären kapazitiven Einflüsse auf einzelne Elemente der integrierten Schaltung verringert sind. Dieses Problem wird durch die Merkmale des Anspruchs 1 gelöst. Weiterhin soll bei der Herstellung der technologische Ablauf zur Realisierung des Kontakt- und Leitbahnsystems moderner CMOS-Technologien nicht nachteilig beeinflußt sein und insbesondere keine zusätzlichen Planarisierungsschritte erforderlich werden.

Diese Aufgabenstellung wird durch eine partielle, mindestens 5 µm dicke Isolierschicht, die auf den Bereich der Elemente der integrierten Schaltung lokal begrenzt und im Halbleitersubstrat versenkt ist, gelöst.

Die durch parasitäre Einflüsse bedingten Verluste, die vom spezifischen elektrischen Widerstand des verwendeten Siliziumsubstrates abhängig sind, werden stark verringert, so daß sich z. B. die Güte einer integrierten Induktivität in Abhängigkeit von der gewählten Dicke der vergrabenen Isolierschicht um ca. 40 % und darüber hinaus gegenüber planaren Induktivitäten auf konventioneller CMOS-Basis erhöhen läßt.

Der wesentliche Vorteil dieser hier vorgeschlagenen lokalen Isolationsvariante besteht in der Realisierung des nur auf den Bereich des späteren Elements der integrierten Schaltung begrenzten dicken, versenkten Oxids. Hierdurch werden im nachfolgenden technologischen Prozeß gravierende Unterschiede in den Strukturhöhen - und damit aufwendige Planarisierungsmaßnahmen - vermieden. Der Prozeß zur Herstellung stark skalierter CMOS- oder BiCMOS-Strukturen wird somit nicht nachteilig durch die Notwendigkeit, für die Realisierung von z. B. integrierten Induktivitäten mit hoher Güte zusätzliche dicke Isolationsschichten zwischen Spirale und Substrat einzufügen, beeinflußt. Die Herstellung einer erfindungsgemäßen integrierten Schaltung erfolgt durch die Verfahrensschritte
- Maskierung der Oberfläche des Silizium-Wafers,
- Ausbildung von Gräben und Stegen durch anisotrope Ätzung,
- wahlweise Durchführung einer Opferoxidation, d. h. einer teilweisen Anoxidation der Stege mit nachfolgender Oxidentfernung zur Optimierung des Verhältnisses zwischen den Breiten der Stege und Gräben,
- vollständige Oxidation der Stege zu Siliziumoxid und zumindest oberflächennahes Auffüllen der Gräben durch Abscheidung von Siliziumoxid,
- CMOS-Prozeß oder CMOS-kompatibler Siliziumprozeß mit Herstellung der einzelnen Elemente der integrierten Schaltung unter Nutzung der im jeweiligen Prozeß vorhandenen Teilschritte zur Erzeugung der Elemente der integrierten Schaltung, wobei die Schaltungselemente mit verringrten parasitären Einflüssen oberhalb der Region des vergrabenen dicken Oxids erzeugt werden.

In einem nicht beanspruchten Verfahren läßt sich eine integrierte Schaltung auch durch die Verfahrensschritte
- Maskierung der Oberfläche eines p-Silizium-Wafers,
- Umwandlung der nicht maskierten Bereiche des p-Siliziums in poröses Silizium,
- Oxidation der porösen Siliziumschicht in Siliziumoxid,
- CMOS-Prozeß oder CMOS-kompatibler Siliziumprozeß mit Herstellung der einzelnen Elemente der integrierten Schaltung unter Nutzung der im jeweiligen Prozeß vorhandenen Teilschritte zur Erzeugung der Elemente der integrierten Schaltung, wobei speziell die Schaltungselemente mit veringerten kapazitiven Einflüssen oberhalb der Region des vergrabenen dicken Oxids erzeugt werden,
herstellen.

Die Merkmale der Erfindung gehen außer aus den Ansprüchen auch aus der Beschreibung und den Zeichnungen hervor, wobei die einzelnen Merkmale jeweils für sich allein oder zu mehreren in Form von Unterkombinationen schutzfähige Ausführungen darstellen, für die hier

Schutz beansprucht wird. Ein Ausführungsbeispiel wird im folgenden näher erläutert.

Die Figuren zeigen:
Fig. 1 schematischer Aufbau einer Induktivität in Draufsicht
Fig. 2 schematischer Schnitt einer Induktivität

### Beispiel 1 (Ausführungsbeispiel) :

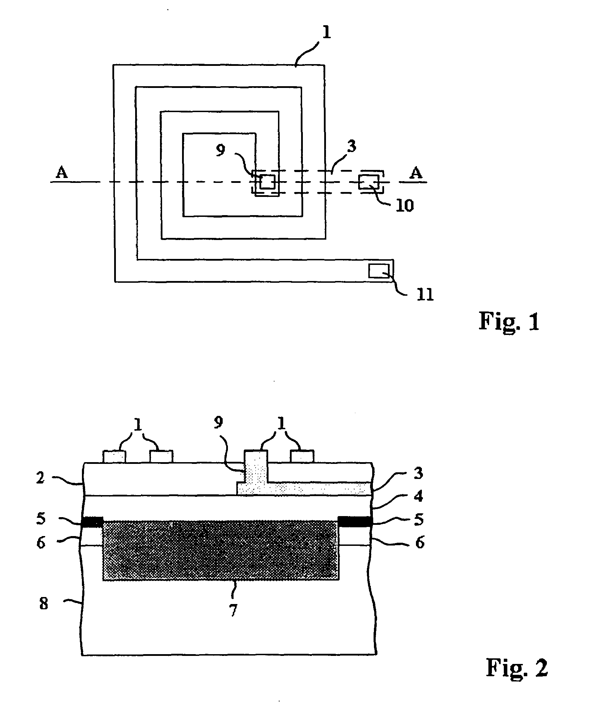

Fig. 1 zeigt den schematischen Aufbau einer Induktivität als Teil einer erfindungsgemäßen integrierten Schaltung in Draufsicht, in Fig. 2 wird eine Schnittdarstellung der Induktivität gezeigt. Die integrierte Induktivität besteht aus einer oberen Metallebene **1** zur Realisierung einer Spirale, einer Isolationsschicht **2**, einer unteren Metallebene **3** zur Kontaktherstellung des inneren Anschlusses **10**, einer Isolationsschicht **4**, einer Feldoxidschicht **5**, einer Kanalstopperschicht **6**, einer vergrabenen, dicken lokalen Isolationsschicht **7** sowie dem Halbleitersubstrat **8**. Die Feldoxidschicht **5** sowie die Kanalstopperschicht **6** befinden sich nur außerhalb des Gebiets der integrierten Induktivität. Die vergrabene, dicke lokale Isolationsschicht **7** ist nur im Bereich der Induktivität unterhalb der Metallschichten **1, 3** angeordnet.

Zur Herstellung der Induktivität werden in einen Silizium-Wafer mit Hilfe einer Ätzmaske im Bereich der im nachfolgenden Prozeß zu realisierenden integrierten Induktivität mit einem anisotropen Ätzverfahren Gräben von ca. 10 µm Tiefe derart geätzt, daß im Wechsel Gräben und Stege entstehen. Die Breite der Stege und Gräben wird so gewählt, daß bei einer nachfolgenden vollständigen Umwandlung der Stege in Siliziumdioxid mittels eines thermischen Oxidationsprozesses die Gräben bis auf eine Restbreite von ca. 100 nm bis 300 nm geschlossen werden. Aufgrund des Volumenzuwachses ergeben z. B. Stege von 0,8 µm Breite und Gräben von 1,2 µm Breite nach vollständiger Oxidation der Stege Restgräben von ca. 150 nm bis 200 nm Breite. Gegebenenfalls kann eine Feinoptimierung des Verhältnisses der Breiten der Stege und der Gräben durch eine vorgelagerte Opferoxidation, d. h. eine teilweise Anoxidation der Stege mit nachfolgender Oxidentfernung durchgeführt werden. Die nach vollständiger Oxidation verbleibenden Restgräben werden mittels einer abschließenden Abscheidung von Siliziumdioxid, z. B. durch CVD-Prozeß, zumindest oberflächennah vollständig geschlossen. Durch diesen Ablauf entsteht eine versenkte Isolationsschicht **7**, deren Dicke durch die Tiefe der geätzten Gräben definiert ist. Nach Entfernung der CVD-Oxidschicht von der Oberfläche und der Ätzmaske für das Grabenätzen schließt sich der jeweils verwendete CMOS-Prozeß an. Alternativ kann die Ätzmaske bereits vor der Oxidation der Stege ganz oder teilweise entfernt werden. Die integrierte Induktivität wird unter Verwendung des in diesem CMOS-Prozeß vorhandenen Kontakt- und Leitbahnsystems oberhalb der vergrabenen, dicken Isolationsschicht **7** realisiert.

### Beispiel 2:

In einem nicht beanspruchten Verfahren wird eine integrierte Induktivität durch folgende Verfahrensschritte hergestellt: Ein p-Silizium-Wafer wird auf der Oberfläche maskiert, und es erfolgt anschließend eine Umwandlung der nicht maskierten Bereiche des p-Siliziums in poröses Silizium bis zu einer Dicke der porösen Siliziumschicht zwischen 6 µm und 20 µm mittels anodischer Reaktion in Flußsäure. Die gewünschte Dicke der porösen Siliziumschicht wird über das Stomstärke-Zeit-Produkt eingestellt. Die Stromdichte liegt dabei zwischen 10 mA · cm⁻² und 100 mA · cm⁻², vorzugsweise zwischen 40 mA · cm⁻² und 50 mA · cm⁻². Die Porösität wird maßgeblich durch die Konzentration der Flußsäure bestimmt. In diesem Beispiel liegt die Konzentration der Flußsäure, bezogen auf die Masseanteile, zwischen 40 % und 50 %. Die poröse Siliziumschicht wird nachfolgend oxidiert. In Abhängigkeit von den Dickenverhältnissen zwischen der zu oxidierenden porösen Siliziumschicht und der anschließend herzustellenden Feldoxidschicht **5** liegt es im Bereich der Erfindung, diese Oxidation mit der Realisierung der Feldoxidationsschicht **5** zu kombinieren. Durch geeignete Wahl der Anodisationsbedingungen ist eine optimale Porösität des Silizium von ca. 56 % anzustreben, damit die bei der Umwandlung des Siliziums in Siliziumdioxid auftretende Volumenänderung berücksichtigt wird, um die resultierenden Verspannungen zu minimieren. Die weiteren Verfahrensschritte bis zur fertigen Herstellung der integrierten Induktivität erfolgen analog zum Ausführungsbeispiel.

In der vorliegenden Erfindung wurde anhand eines konkreten Ausführungsbeispiels eine integrierte Schaltung mit verringerten parasitären kapazitiven Einflüssen und ein Verfahren zu ihrer Herstellung erläutert. Es sei aber vermerkt, daß die vorliegende Erfindung nicht auf die Einzelheiten der Beschreibung in dem Ausführungsbeispiel eingeschränkt ist, da im Rahmen der Patentansprüche Änderungen und Abwandlungen beansprucht werden. Neben der Anwendung zur Herstellung einer integrierten Induktivität eignet sich die Verwendung einer Isolierschicht, die auf den Bereich der Elemente der integrierten Schaltung lokal begrenzt und im Halbleitersubstrat versenkt ist, nicht nur für integrierte Induktivitäten, sondern auch für andere Elemente der integrierten Schaltung, insbesondere weitere passive Bauelemente wie Widerstände und Kapazitäten, aber auch für Leiterbahnen und Bondinseln.

## Patentansprüche

1. Verfahren zur Herstellung einer integrierten Schaltung mit lokaler vergrabener Isolation, mit den Verfahrensschritten:
- Maskierung der Oberfläche eines Silizium-Wafers,
- Ausbildung von Gräben und Stegen durch anisotrope Ätzung, wobei Gräben von mindestens 5 µm Tiefe derart geätzt werden, daß Stege von ca. 0,8 µm Breite und Gräben von ca. 1,2 µm Breite entstehen,
- vollständige Oxidation der Stege zu Siliziumoxid und zumindest oberflächennahes Auffüllen von Restaräben durch Abscheidung von Siliziumoxid, wobei eine dicke Oxidschicht (7) entsteht.
- CMOS-Prozeß oder CMOS-kompatibler Siliziumprozeß mit Herstellung der integrierten Schaltung unter Nutzung der im jeweiligen Prozeß vorhandenen Teilschritte zur Erzeugung der Elemente der integrierten Schaltung, wobei die Schaltungselemente mit verringerten parasitären Einflüssen oberhalb der Region der vergrabenen dicken Oxidschicht (7) erzeugt werden.

2. Verfahren nach Anspruch 1, mit einem zusätzlichen Schritt einer Opferoxidation, d. h. einer teilweisen Anoxidation der Stege mit nachfolgender Oxidentfernung zur Optimierung des Verhältnisses zwischen den Breiten der Stege und Gräben, nach der Ausbildung von Gräben und Stegen.

3. Verfahren nach Anspruch 1 oder 2, bei dem der CMOS-Prozeß oder der CMOS-kompatible Siliziumprozeß die Herstellung einer Induktivität unter Nutzung des im jeweiligen Prozeß vorhandenen Kontakt- und Leitbahnsystems oberhalb der Region der vergrabenen dicken Oxidschicht (7) umfasst.

4. Verfahren nach Anspruch 1 oder 2, bei dem Gräben von mindestens 5 µm Tiefe derart geätzt werden, daß die Breite der Stege und Gräben so gewählt wird, daß bei einer nachfolgenden vollständigen Umwandlung der Stege in Siliziumdioxid mittels Oxidation die Gräben bis auf eine Restbreite von ca. 100 nm bis 300 nm geschlossen werden.

## Claims

1. Method of producing an integrated circuit with locally buried insulation, comprising the following process steps:
- masking the surface of a silicon wafer,
- forming channels and gates by anisotropic etching, whereby channels at least 5 µm deep are etched such that gates about 0.8 µm wide and channels about 1.2 µm wide are formed,
- total oxidation of the gates to form silicon oxide and filling the residual channels to a level at least close to the surface by the precipitation of silicon oxide, forming a thick oxide layer (7).
- CMOS process or CMOS-compatible silicon process with manufacture of the integrated circuit using the partial steps which are included in the respective process in order to produce the elements of the integrated circuit, the circuit elements being produced with reduced parasitic influences above the region of the buried thick oxide layer (7).

2. Method according to claim 1, having an additional step of sacrificial oxidation, i.e. partial anoxidation of the gates with subsequent oxide removal to optimise the ratio between the widths of the gates and channels, after the formation of channels and gates.

3. Method according to claim 1 or 2, wherein the CMOS process or the CMOS-compatible silicon process comprises producing inductivity using the contact and conductor system present in the respective process above the region of the buried thick oxide layer (7),

4. Method according to claim 1 or 2, wherein channels at least 5 µm deep are etched such that the width of the gates and channels is selected so that during subsequent total conversion of the gates into silicon dioxide by oxidation, the gates are closed off apart from a residual width of about 100 nm to 300 nm.

## Revendications

1. Procédé de fabrication de circuit intégré comportant une isolation locale enterrée, comportant les étapes de procédé consistant en :
- un masquage de la surface d'une tranche de silicium,
- une réalisation de tranchées et de nervures par gravure anisotropique, où les tranchées sont gravées à une profondeur d'au moins 5 µm de sorte que les nervures présentent une largeur d'environ 0,8 µm et les tranchées une largeur d'environ 1,2 µm,
- l'oxydation totale des nervures en oxyde de silicium et le remplissage au moins presque jusqu'à la surface des tranchées résiduelles par dépôt de l'oxyde de silicium, où se trouve une couche d'oxyde épaisse (7),
- un processus CMOS ou un processus siliceux compatible CMOS avec la fabrication du circuit intégré en utilisant les étapes partielles existant dans le processus respectif pour fabriquer les éléments du circuit intégré, où les éléments de circuit comportant des influences parasites réduites sont fabriqués au-dessus de la région de la couche d'oxyde épaisse enterrée (7).

2. Procédé selon la revendication 1, comportant une étape supplémentaire d'oxydation sacrificielle, c'est-à-dire une anoxydation partielle des nervures avec l'élimination d'oxyde ultérieure pour l'optimisation du rapport entre les largeurs des nervures et des tranchées, après la réalisation des tranchées et des nervures.

3. Procédé selon la revendication 1 ou 2, dans lequel le processus CMOS ou le processus siliceux compatible CMOS comprend la fabrication d'une inductivité en utilisant le système par contact et par pistes conductrices existant dans le processus respectif au-dessus de la région de la couche d'oxyde enterrée épaisse (7).

4. Procédé selon la revendication 1 ou 2, dans lequel les tranchées sont gravées à une profondeur d'au moins 5 µm de sorte que la largeur des nervures et des tranchées est choisie de sorte que, dans le cas d'une conversion totale suivante des nervures en dioxyde de silicium grâce à l'oxydation, les tranchées sont fermées jusqu'à une largeur résiduelle d'environ 100 nm jusqu'à 300 nm.
